# EUROPÄISCHE PATENTSCHRIFT

(11) **EP 0 738 103 B1**
(45) Veröffentlichungstag und Bekanntmachung des Hinweises auf die Patenterteilung: **19.01.2000**
(21) Anmeldenummer: 96104219.9
(22) Anmeldetag: 16.03.1996
(51) Int. Cl.: H05K 13/00, B65H 3/24

(54) **Verfahren und Vorrichtung zum vollautomatischen Handhaben von elektrisch zu prüfenden Prüflingen**
Process and device for the automatic handling of objects to be electrically tested
Procédé et dispositif pour manipulation automatique d'échantillons à tester électriquement

(30) Priorität: 15.04.1995 DE 19514163
(43) Veröffentlichungstag der Anmeldung: 16.10.1996
(73) Patentinhaber: atg test systems GmbH, 97877 Wertheim (DE)
(72) Erfinder: Happ, Christian, 97877 Mondfeld (DE); Geier, Rudolf, 97900 Külsheim-Hundheim (DE)
(74) Vertreter: Ganahl, Bernhard

(56) Entgegenhaltungen:
- DE-A- 2 840 677
- GB-A- 2 119 761
- GB-A- 2 213 474
- US-A- 1 924 908

## Beschreibung

Die vorliegende Erfindung betrifft ein Verfahren zum vollautomatischen Handhaben von elektrisch zu prüfenden Prüflingen, insbesondere plattenförmigen Produkten, vorzugsweise Leiterplatten, sowie eine Vorrichtung zum Ausführen dieses Verfahrens.

Aus dem Stand der Technik sind bereits in vielfältiger Weise Verfahren zur Handhabung von platten- oder kartenförmigen Gegenständen allgemein und insbesondere von elektrisch zu prüfenden Leiterplatten bekannt. Sie alle sind jedoch hinsichtlich Durchsatz, Zuverlässigkeit sowie konstruktivem Aufwand verbesserungswürdig. Insbesondere treten immer wieder Probleme beim Vereinzeln beziehungsweise dem präzisen Zuführen der Leiterplatten zu den Prüfeinrichtungen auf.

Auch die Umrüstung der bekannten Vorrichtungen auf einen neuen Typ von Leiterplatten ist zeitaufwendig und daher verbesserungswürdig.

In GB 2 213 474 A1 ist eine Kartenzuführvorrichtung beschrieben, bei der ein verlagerbarer Stößel auf eine Seitenfläche von Karten in einem Stapel wirkt. Dieser Stößel drückt Karten des Stapels gegen einen von einer Wand eines Kartenschachts gebildeten Anschlag, um die untersten Karten des Stapels vom Gewicht der darüber befindlichen zu entlasten und so die Entnahme von Karten vom unteren Ende des Stapels zu erleichtern.

DE 24 80 677 A1 zeigt eine Vereinzelungseinrichtung für plattenförmige Gegenstände, mit einem verlagerbaren Stößel, der auf eine Seitenfläche genau eines Gegenstands wirkt, um ihn seitwärts auf einen Tisch zu verschieben.

Aus US 1 924 908 A ist eine Vereinzelungseinrichtung mit einem Anschlag bekannt, der eine höhenabhängige Kontur aufweist. Mit dem Anschlag wirkt ein Arm zusammen, der allerdings nicht wie ein Stößel bewegbar ist und deshalb nur geringe Kräfte in Richtung des Anschlags ausüben kann. Die Vorrichtung ist deshalb nur für leichte, nicht aneinanderhaftende Gegenstände geeignet.

Die Aufgabe der vorliegenden Erfindung besteht deshalb darin, ein Verfahren sowie eine Vorrichtung zum Ausführen dieses Verfahrens anzugeben, das beziehungsweise die eine verbesserte Handhabung von elektrisch zu prüfenden Prüflingen erlaubt, bei denen die Gefahr eines Aneinanderhaftens besteht.

Diese Aufgabe wird durch die Merkmale des Patentanspruchs 1 beziehungsweise des Patentanspruchs 6 gelöst. Dadurch, daß die aufeinanderliegenden Prüflinge relativ zu dem darunter und/oder darüber liegenden Prüfling verschoben werden, können Haft- oder Klebeverbindungen zwischen den einzelnen Prüflingen aufgelöst und damit die Vereinzelbarkeit verbessert werden. Insbesondere können mit dem Verfahren beziehungsweise der Vorrichtung universelle Produktformen mit unterschiedlichen Produktstärken transportiert werden. Vorzugsweise werden die einzelnen Prüflinge schrittweise um jeweils kleine Beträge verschoben. Das Verschieben der einzelnen Prüflinge wird mittels eines Stößels ausgeführt, der auf die Seitenflächen der gestapelten Prüflinge einwirkt und diese gegen den Anschlag drückt oder auf diesen zubewegt. Der Anschlag weist eine höhenabhängige Kontur auf, wobei die Kontur des Stößels an die Kontur des Anschlags angepaßt ist. Durch eine zyklische Hubbewegung des Stößels wird in vorteilhafter Weise jeder Prüfling mehrfach beaufschlagt, wobei durch die zuvor genannte Positionsveränderung des Anschlags und das Anheben des Produktstapels ein schrittweises Verschieben stattfindet.

Anschließend findet eine Ausrichtung des obersten Prüflings in der horizontalen Ebene statt, so daß er in einer vordefinierten Position vorzugsweise schräg abgehoben und in die Prüfposition gebracht werden kann. Nach dem Durchführen der elektrischen Prüfung wird der Prüfling in eine Ablageposition ausgetragen. Vorzugsweise sind mehrere Ablagepositionen vorgesehen, wobei die Zuordnung des jeweiligen Prüflings zu einer Ablageposition abhängig vom Prüfergebnis erfolgt.

In einer weiteren Ausgestaltung der Erfindung wird der Prüfling vor dem Abheben aus dem Produktstapel in eine zweite Ausrichtposition gebracht, so daß insgesamt also ein zweistufiges Ausrichten erfolgt, nämlich zuerst grob und dann fein.

In bevorzugter Weise findet auch beim Absenken in die Prüfposition eine nochmalige Fein-Ausrichtung des Prüflings statt, so daß die anschließende elektrische Prüfung zuverlässig durchgeführt werden kann.

In einer weiteren vorteilhaften Ausgestaltung der Erfindung wird der auf dem Produktstapel oben aufliegende Prüfling durch Anheben des gesamten Produktstapels in die Ausgangsposition gebracht.

In einer bevorzugten Ausführungsform ist eine erste Transportvorrichtung vorgesehen, die den Prüfling in die Prüfposition transportiert. Zum Anheben und Transportieren des Prüflings ist die Transportvorrichtung mit einer Halte- und Ausrichtvorrichtung versehen, die zum einen speziell auf den Prufling abgestimmt und darüber hinaus schnell auswechselbar ist. Beim Wechsel von einem Prüflingstyp zum anderen ist die Rüstzeit sehr gering. Vorzugsweise arbeitet eine zweite Transportvorrichtung mit der ersten Transportvorrichtung zusammen, wobei die zweite Transportvorrichtung den Prüfling aus der Prüfposition in eine Ablageposition bringt, während zur gleichen Zeit die erste Transportvorrichtung einen Prüfling in die Prüfposition transportiert. Der Durchsatz läßt sich damit erhöhen.

Weitere vorteilhafte Ausgestaltungen sind den Unteransprüchen zu entnehmen.

Anhand der Zeichnung wird im folgenden ein Ausführungsbeispiel näher beschrieben. Dabei zeigen:
- Figur 1a: schematisch eine Seitenansicht der erfindungsgemäßen Vorrichtung;
- Figur 1b: eine schematische Draufsicht der in Figur 1 gezeigten Vorrichtung;
- Figur 2a: einen Ausschnitt der erfindungsgemäßen Vorrichtung;
- Figur 2b: eine Draufsicht des in Figur 2a gezeigten Ausführungsbeispiels;
- Figuren 3a, b und c: schematisch einen Ausschnitt einer Transportvorrichtung in drei unterschiedlichen Positionen.

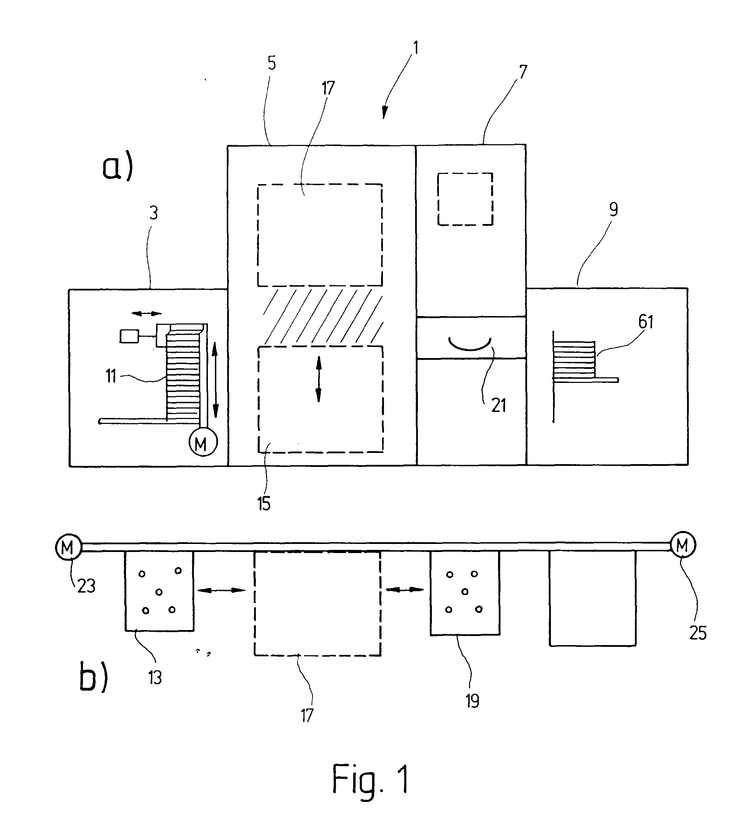

Die in Figur 1 lediglich schematisch gezeigte Vorrichtung 1 zum Handhaben von elektrischen Prüflingen kann im wesentlichen in vier Bereiche 3, 5, 7 und 9 aufgeteilt werden. Die elektrisch zu prüfenden Prüflinge, bei denen es sich vorzugsweise um Leiterplatten handelt, werden zunächst in den Ausgangsbereich 3 gebracht und dort gepuffert. Die Anlieferung der Leiterplatten zur Vorrichtung 1 erfolgt dabei entweder bereits in gestapelter Form oder einzeln, wobei dann die Stapelung im Bereich 3 stattfindet.

Aus dem Produktstapel 11 hebt eine in Figur 1b schematisch dargestellte Transportvorrichtung 13 die oberste Leiterplatte ab und führt sie dem nachfolgenden Prüfbereich 5 zu. Dort sind zwei Prüfadapter 15 und 17 vorgesehen, die der Unterseite beziehungsweise der Oberseite der Leiterplatte zugeordnet sind.

Als Adapter 15, 17 kommt jeweils beispielsweise ein Nadeladapter, ein Pintranslator oder ein Gummitranslator zum Einsatz. Auch eine Kombination unterschiedlicher Adaptersysteme ist möglich.

Sobald die elektrische Prüfung der Leiterplatte beendet ist, nimmt eine zweite Transportvorrichtung 19 die Leiterplatte auf und transportiert sie in einen nachfolgenden Ablagebereich. Hat die elektrische Prüfung einen Fehler erkannt, legt die zweite Transportvorrichtung 19 die Leiterplatte im Ablagebereich 7 in einer sogenannten "Schlecht-Schublade" 21 ab. Ist die Leiterplatte jedoch fehlerfrei, gelangt sie in den Ablagebereich 9. Wie im Ausgangsbereich 3 werden die einzelnen Leiterplatten auch im Ablagebereich 9 gestapelt. So können die geprüften Leiterplatten in einfacher Weise beispielsweise nachfolgenden Bestückungsautomaten zugeführt werden.

In der Figur 1b sind zwei Motoren 23, 25 zu erkennen, wobei der Motor 23 der Transportvorrichtung 13 und der Motor 25 der Transportvorrichtung 19 zugeordnet ist. Die Kopplung zwischen Motor und Transportvorrichtung erfolgt beispielsweise über Riemen.

Die beiden Transportvorrichtungen 13, 19 arbeiten so zusammen, daß sich eine ungeprüfte Leiterplatte vom Produktstapel 11 bereits auf dem Weg zum Prüfbereich 5 befindet, während die geprüfte Leiterplatte aus dem Prüfadapter herausgenommen und in den Ablagebereich 7 beziehungsweise 9 transportiert wird. Somit erhöht sich der Durchsatz, indem die Leerzeit zwischen zwei Prüfungen verringert wird.

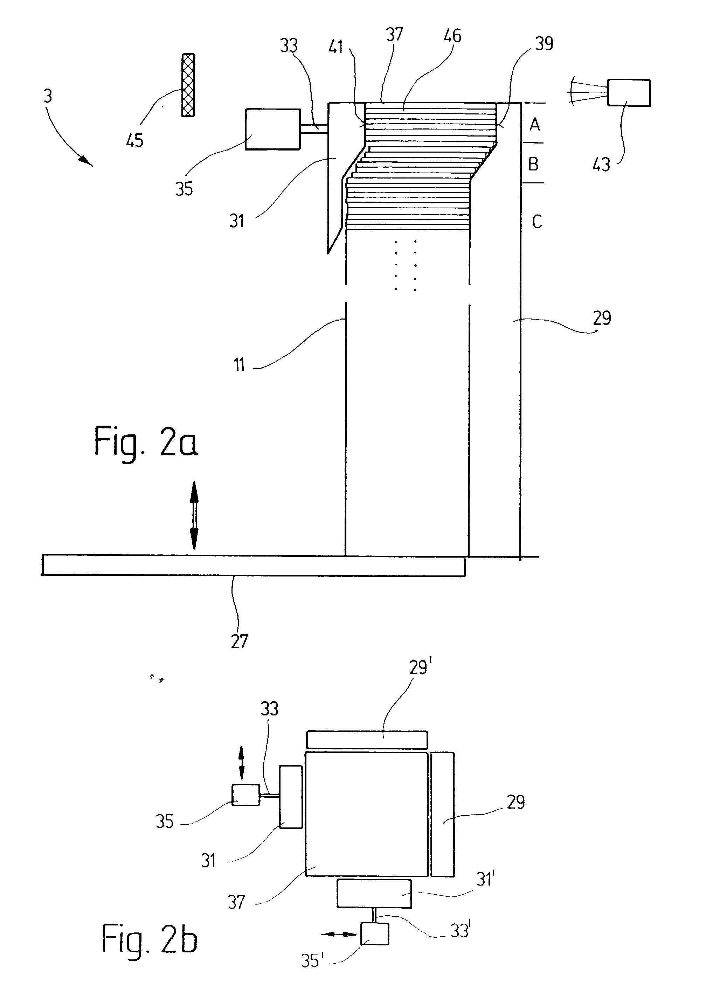

Mit Bezug auf die Figur 2a wird nun der Ausgangsbereich 3 näher erläutert. Der aus vielen übereinander liegenden Leiterplatten bestehende Produktstapel 11 steht auf einem Hubtisch 27, der mittels eines nicht gezeigten Antriebs in vertikaler Richtung verfahrbar ist. Seitlich stützt beziehungsweise führt eine Führungsleiste 29 den Produktstapel 11. Im vorliegenden Ausführungsbeispiel wirkt die Führungsleiste 29 jeweils nur mit einer Kantenfläche einer Leiterplatte des Stapels 11 zusammen.

Im oberen Bereich des Produktstapels 11 ist ein Stößel 31 der Führungsleiste 29 gegenüberliegend angeordnet. Eine Stange 33 verbindet den Stößel 31 mit einem Zylinder 35, der nach seiner Aktivierung den Stößel 31 zu einer Hubbewegung vorzugsweise mit einer Frequenz von 1 Hz antreibt.

Durch die Hubbewegung kommt der Stößel 31 in Kontakt mit den angrenzenden Kantenflächen der im Wirkungsbereich liegenden Leiterplatten und verschiebt diese zur Führungsleiste 29 hin. Je nach Maßhaltigkeit der Leiterplattenabmessung liegen die Leiterplatten mehr oder weniger dicht an der Führungsleiste 29 an. Die Leiterplatten sind somit nach der Stößelbeaufschlagung grob ausgerichtet.

Um das Vereinzeln beim Abheben der oberen Leiterplatte 37 vom Stapel 11 zu erleichtern, weist die den Leiterplatten zugewandte Seitenfläche 39 der Führungsleiste 29 eine höhenabhängige Kontur auf. So ist die Seitenfläche 39 im oberen Bereich A zurückversetzt gegenüber dem unteren Bereich C der Seitenfläche 39, wobei der Übergang B vom Bereich C in den Bereich A vorzugsweise gleichmäßig verläuft.

Die Innenfläche 41 des Stößels 31 weist eine Kontur auf, die quasi ein negatives Abbild der gegenüberliegenden Seitenfläche 39 der Führungsleiste 29 ist. Mithin ist also der horizontale Abstand zwischen Innenfläche 41 und Seitenfläche 39 im Wirkungsbereich des Stößel 31 im wesentlichen konstant.

Im oberen Bereich des Produktstapels 11 ist darüber hinaus eine Lichtschranke vorgesehen, die sich aus einer Lichtquelle/Sensor-Baueinheit 43 und einem Reflektor 45 zusammensetzt. Das von der Baueinheit 43 ausgesandte Licht trifft auf den Reflektor 45, wird zurück zu der Baueinheit 43 reflektiert und dort detektiert. Die Ausrichtung der Lichtschranke erfolgt dabei so, daß erfaßbar ist, ob die obere Leiterplatte 37 an der richtigen Position liegt. Sobald die obere Platte 37 von der Transportvorrichtung 13 abgenommen und in den Bereich 5 transportiert wurde, aktiviert die Lichtschranke 43 einen nicht dargestellten Motor, der den Hubtisch 27 so weit nach oben fährt, bis die jetzt oben liegende Leiterplatte 46 an der richtigen Position liegt.

Nach jedem Anheben des Produktstapels 11 verlieren die im Bereich B liegenden Leiterplatten den Kontakt mit der Seitenfläche 39. Erst bei der nächsten Hubbewegung des Stößels 31 werden diese Leiterplatten wieder an die Seitenfläche 39 angedrückt. Mit Hilfe der geneigten Seitenfläche 39 im Bereich B wird sicher gewährleistet, daß sich zwei aufeinander liegende Leiterplatten relativ zueinander verschieben. Somit werden die zwischen Leiterplatten häufig bestehenden Klebe- oder Haftverbindungen aufgelöst, so daß das Abheben der oberen Leiterplatte 37 fehlerfrei abläuft, ohne daß die darunter liegende Leiterplatte 46 aufgrund der Verbindung mitgenommen wird. Insbesondere erfolgt die Leiterplattenvereinzelung unabhängig von der Dicke.

Figur 2b zeigt eine Draufsicht des in Figur 2a gezeigten Ausführungsbeispiels. Aus dieser Figur ist ersichtlich, daß eine weitere Einheit aus Stößel 31', Stange 33' und Zylinder 35' vorhanden ist. Der zusätzliche Stößel 31' ist im Winkel von 90° zum zuvor beschriebenen Stößel 31 angeordnet und wirkt mit einer gegenuberliegenden Führungsleiste 29' zusammen, die ebenfalls einen Winkel von 90° mit der Führungsleiste 29 einschließt. Die Funktionsweise dieser zusätzlichen Einheit entspricht der im Zusammenhanag mit Figur 2a bereits beschriebenen Einheit, wobei die Führungsleiste 29' vozugsweise keine höhenabhangige Kontur aufweist.

Die in Figur 2b gezeigten Pfeile sollen andeuten, daß die beiden Einheiten 31, 33, 35 beziehungsweise 31', 33', 35' jeweils in Pfeilrichtung verschiebbar angeordnet sind.

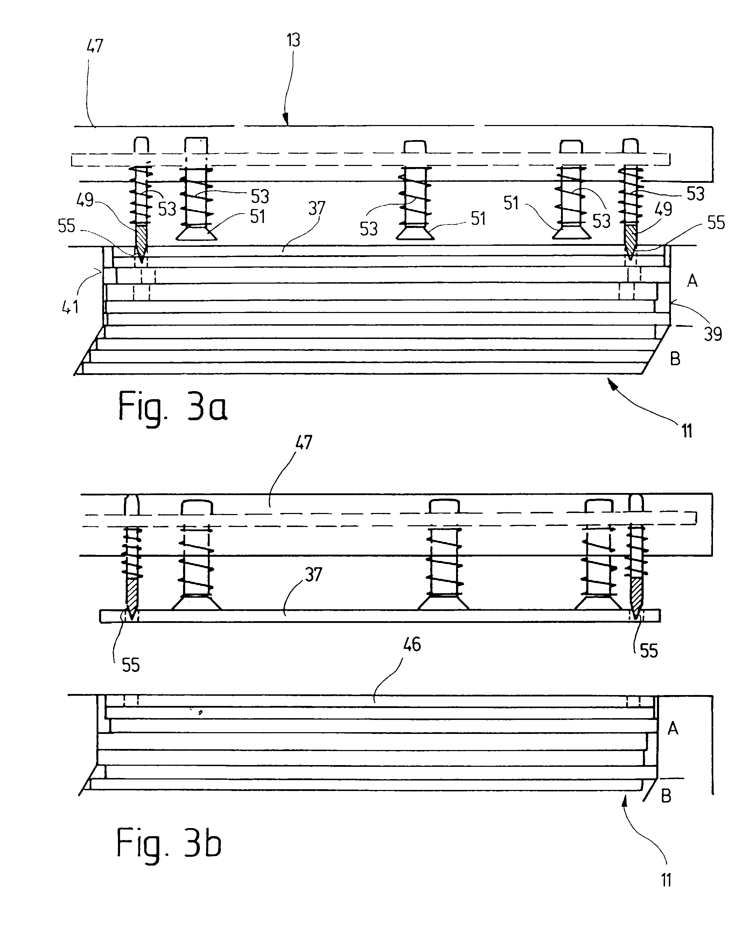

Mit Bezug auf die Figuren 3a bis 3c wird im folgenden das Abheben der oberen Leiterplatte 37 vom Produktstapel und deren Transport in den Prüfbereich 5 detailliert beschrieben.

Die gezeigte Transportvorrichtung 13 umfaßt eine Transportplatte 47, Ausrichtungsdorne 49 (Fixierstift gefedert) und Vakuumsauger 51. Sowohl die Ausrichtungsdorne 49 als auch die Vakuumsauger 51 sind in der Transportplatte 47 vertikal verschiebbar angeordnet, wobei jeweils ein Teil über die Transportplattenoberfläche hinaus ragt. Die Ausrichtungsdorne 49 stehen um einen größeren Betrag über als die Vakuumsauger 51. Jedem Ausrichtungsdorn 49 und jedem Vakuumsauger 51 ist eine Feder 53 zugeordnet, die jeweils eine definierte Position sicherstellt.

Die Anordnung der Ausrichtungsdorne 49 und der Vakuumsauger 51 auf der Transportplatte 47 erfolgt abhängig von den zu prüfenden Leiterplatten. Die Ausrichtungsdorne 49 sollen mit Ausrichtungsbohrungen 55 in der Leiterplatte zusammenwirken, während die Vakuumsauger 51 nur an Leiterplattenbereichen ansaugen dürfen, die keine oder nur wenig Bohrungen aufweisen.

Zum Anheben der Leiterplatte 37 wird die Transportplatte 47 zunächst über die Leiterplatte 37 gebracht und dann abgesetzt. Beim Absetzen greifen die Spitzen der Ausrichtungsdorne 49 in die Ausrichtungsbohrungen 55 ein. Durch die konische Ausbildung der Ausrichtungsdorne 49 und die entsprechende Anpassung der Bohrungen 55 an den Durchmesser der Dorne 49 wird die Leiterplatte 37 in eine definierte Position relativ zur Transportplatte 47 gebracht. Nach dieser Feinausrichtung werden die Vakuumsauger 51 aktiviert, die die Leiterplatte 37 gegen die Federkraft der den Ausrichtungsdornen 49 zugeordneten Federn 53 ansaugen und festhalten. Die Transportplatte 47 wird dann etwas angehoben, wie dies in Figur 3b dargestellt ist.

Sobald die Leiterplatte 37 vom Produktstapel 11 abgehoben ist, aktiviert die Lichtschranke 43 den Hubtischantrieb, der daraufhin die Leiterplatte 46 an die Position der vorhergehenden Leiterplatte 37 bringt.

In den beiden Figuren 3a und 3b sind die Leiterplatten im Bereich A nicht bündig zueinander dargestellt. Damit soll zum Ausdruck gebracht werden, daß in diesem Bereich noch keine Feinausrichtung stattfindet. Das Zusammenwirken von Stößel und Führungsleiste soll lediglich zu einer Grobausrichtung führen, so daß auf jeden Fall gewährleistet ist, daß die Ausrichtungsdorne 49 in die Ausrichtungsbohrungen 55 eingreifen. Der Versatz der oberen Leiterplatte gegenüber der optimalen Positon kann somit innerhalb eines Bereichs liegen, der die Hälfte des Durchmessers der Ausrichtungsbohrung beträgt. Dementsprechend sind große Toleranzen in den Außenkonturen der Produkte möglich.

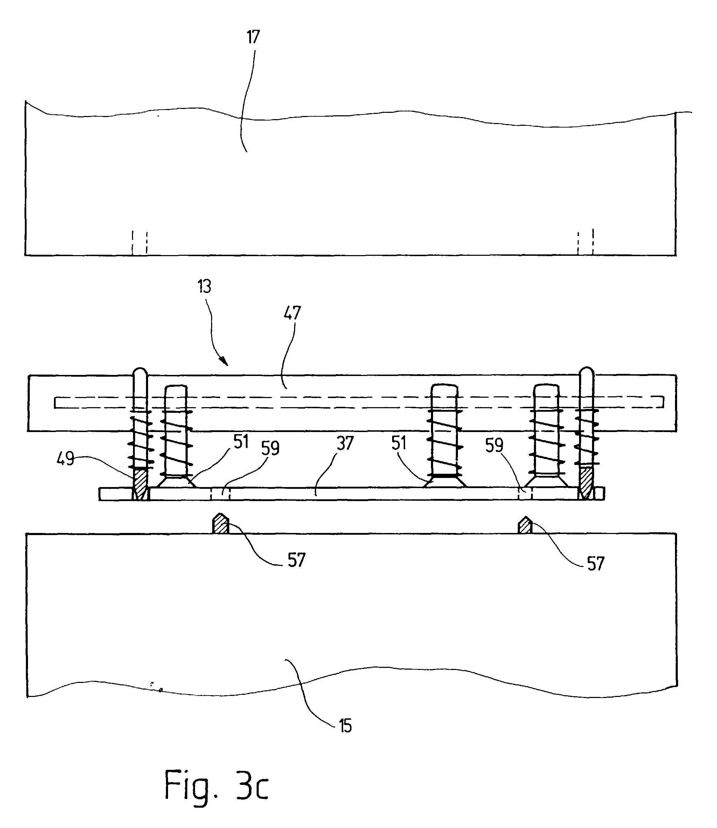

Die abgehobene Leiterplatte 37 wird dann aus dem Ausgangsbereich 3 in den Prüfbereich 5 transportiert, wie dies in Figur 3c dargestellt ist. Die Transportvorrichtung 13 bringt die Leiterplatte 37 in eine Position, bei der weitere Aufnahmebohrungen 59 in der Leiterplatte 37 über Ausrichtungsdornen 57, die am Prüfadapter 15 vorgesehen sind, zu liegen kommen. Beim Absenken der Leiterplatte 37 greifen die Ausrichtungsdorne 57 in die entsprechenden Aufnahmebohrungen 59 ein und bringen somit die Leiterplatte in eine genau definierte Position. Die Vakuumsauger 51 werden deaktiviert, und die Transportvorrichtung 13 löst sich dann von der Leiterplatte 37 und fährt in den Ausgangsbereich 3 zum Abheben einer neuen Leiterplatte zurück.

Nachdem die Transportvorrichtung 13 den Prüfbereich 5 verlassen hat, wird der Prüfadapter 17 auf die Leiterplatte 37 aufgesetzt und mit der elektrischen Prüfung begonnen. Nach der Prüfung wird die Leiterplatte 37 von der zweiten Transportvorrichtung, deren Aufbau der ersten Transportvorrichtung entspricht, aufgenommen und im Fehler-Fall in die Schlecht-Schublade 21, im Gut-Fall in einen Ablagestapel 61 gebracht.

Durch die drei Stufen kann auf teuere Handhabungs-Mechanik verzichtet werden.

Die geforderte Genauigkeit wird an der Stelle erbracht, an der sie auch beim Testen benötigt wird.

Sofern keine hohen Anforderungen an die Ausrichtung der Leiterplatte 37 im Ablagestapel 61 verlangt werden, kann auf Ausrichtungsdorne 49 in der zweiten Transportvorrichtung verzichtet werden.

## Patentansprüche

1. Verfahren zum vollautomatischen Handhaben von elektrisch zu prüfenden Prüflingen, insbesondere plattenförmigen Produkten, vorzugsweise Leiterplatten, wobei folgende Schritte erfolgen:
Bereitstellen der Prüflinge in aufeinanderliegendem Zustand als Produktstapel;
Verschieben der aufeinanderliegenden Prüflinge relativ zu dem oder den benachbarten Prüfling(en) durch Anheben des Produktstapels und Andrücken des Produktstapels an eine höhenabhängige Kontur eines Anschlags mit Hilfe eines Stößels, der eine an die Kontur des Anschlags angepaßte höhenabhängige Kontur besitzt;
Ausrichten des jeweils obersten Prüflings in eine erste Ausrichtposition;
Anheben des jeweils obersten Prüflings und dadurch Abheben vom Produktstapel;
Verbringen des angehobenen Prüflings in eine Prüfposition;
Durchführen der elektrischen Prüfung und Austragen des geprüften Prüflings in mindestens eine Ablageposition.

2. Verfahren nach Anspruch 1, bei dem der Prüfling vor dem Anheben in eine zweite, genauere Ausrichtposition gebracht wird.

3. Verfahren nach einem der vorhergehenden Ansprüche, bei dem der Prüfling in die Prüfposition abgesenkt wird und beim Absenken eine Ausrichtung erfolgt.

4. Verfahren nach einem der vorhergehenden Ansprüche, beim dem der Prüfling in Abhängigkeit vom Prüfergebnis in eine von zumindest zwei möglichen Ablagepositionen verbracht wird.

5. Verfahren nach einem der vorhergehenden Ansprüche, bei dem der oberste Prüfling durch Anheben des Produktstapels in eine Ausgangsposition für das nachfolgende Anheben gebracht wird.

6. Vorrichtung zum Ausführen des Verfahrens nach einem oder mehreren der vorhergehenden Ansprüche, gekennzeichnet durch einen Hubtisch (27), der den Produktstapel (11) in vertikaler Richtung anhebt, und einen verlagerbaren Stößel (31), der sich in Längsrichtung des Produktstapels innerhalb eines Bereichs erstreckt, der mehrere Prüflinge umfaßt und auf eine Seitenfläche eines Prüflings im Produktstapel (11) wirkt und den Prüfling gegen einen Anschlag (29) schiebt, der eine höhenabhängige Kontur aufweist, an die die Kontur des Stößels (31) angepaßt ist.

7. Vorrichtung nach Anspruch 6, **dadurch gekennzeichnet**, daß der Stößel (31) eine zyklische Hubbewegung ausführt, wobei die Zyklusrate so eingestellt ist, daß jeder Prüfling bis zum Abnehmen vom Produktstapel (11) mehrfach vom Stößel beaufschlagt wird.

8. Vorrichtung nach Anspruch 6 oder 7, **dadurch gekennzeichnet**, daß die Anschlagsfläche (39) zumindest in einem Bereich (B) gegenüber der Vertikalen geneigt ist.

9. Vorrichtung nach einem der Ansprüche 6 bis 8, **gekennzeichnet durch** eine erste Transportvorrichtung (13) zum Verbringen des Prüflings in die Prüfposition, wobei die erste Transportvorrichtung (13) eine prüflingsspezifische Halte- und Ausrichtvorrichtung (47) auswechselbar aufweist.

10. Vorrichtung nach einem der Ansprüche 6 bis 9, **gekennzeichnet durch** eine zweite Transportvorrichtung (19) zum Verbringen des Prüflings in die Ablageposition, wobei die zweite Transportvorrichtung eine prüflingsspezifische Haltevorrichtung (47) auswechselbar aufweist.

11. Vorrichtung nach einem der Ansprüche 6 bis 10, **dadurch gekennzeichnet,** daß die Haltevorrichtung Vakuumsauger (51) aufweist.

12. Vorrichtung nach einem der Ansprüche 6 bis 11, **dadurch gekennzeichnet**, daß die Ausrichtvorrichtung (47) Ausrichtdorne (49) aufweist, die mit Bohrungen (55) im Prüfling zusammenwirken.

13. Vorrichtung nach einem der vorhergehenden Ansprüche, **gekennzeichnet durch** eine erste Transportvorrichtung (13) zum Verbringen des Prüflings in die Prüfposition, wobei die erste Transportvorrichtung (13) eine prüflingsspezifische Halte- und Ausrichtvorrichtung (47) auswechselbar aufweist.

14. Vorrichtung nach einem der vorhergehenden Ansprüche, **gekennzeichnet durch** eine zweite Transportvorrichtung (19) zum Verbringen des Prüflings in die Ablageposition, wobei die zweite Transportvorrichtung eine prüflingsspezifische Haltevorrichtung (47) auswechselbar aufweist.

15. Vorrichtung nach einem der vorhergehenden Ansprüche, **dadurch gekennzeichnet,** daß die Haltevorrichtung Vakuumsauger (51) aufweist.

16. Vorrichtung nach einem der vorhergehenden Ansprüche, **dadurch gekennzeichnet,** daß die Ausrichtvorrichtung (47) Ausrichtdorne (49) aufweist, die mit Bohrungen (55) im Prüfling zusammenwirken.

## Claims

1. A method for fully automated handling test objects to be tested electrically, more particularly plate-shaped products, preferably printed circuit boards, comprising the steps of:
supplying the test objects piled as a product stack;
shifting the piled test objects relative to the adjacent test object(s) by elevating the product stack and urging the product stack against a stop contoured as a function of the level by means of a pusher contoured matching the stop as a function of the level;
aligning each topmost test object in a first alignment position;
elevating each topmost test object and thus picking it from the product stack;
bringing the elevated test object into a testing position;
implementing electrical testing and exiting the tested test object into at least one placement position.

2. The method as set forth in claim 1 wherein before being elevated, the test object is brought into a second, more precise, alignment position.

3. The method as set forth in any of the preceding claims wherein the test object is lowered into a testing position, alignment occurring during lowering.

4. The method as set forth in any of the preceding claims wherein the test object is brought into one of at least two possible placement positions depending on the results of testing.

5. The method as set forth in any of the preceding claims wherein the topmost test object is brought into a starting position for subsequent elevation by elevating the product stack.

6. An apparatus for implementing the method as set forth in any of the preceding claims characterized by an elevator table (27) for elevating the product stack (11) vertically, and a positionable pusher (31) extending in the longitudinal direction of the product stack within a zone comprising several test objects and acting against a side surface area of a test object in the product stack (11) and urging the test object against a stop (29) contoured as a function of the level matching the contour of the pusher (31).

7. The apparatus as set forth in claim 6 **characterized in that** the pusher (31) reciprocates, the cycling rate of which is set so that each test object is impacted multiply by the pusher until being picked from the product stack (11).

8. The apparatus as set forth in claim 6 or 7 **characterized in that** the stop surface (39) is inclined at least in one portion (B) relative to the vertical.

9. The apparatus as set forth in any of the claims 6 to 8 **characterized by** a first transport device (13) which transports the test object into the testing position, the first transport device (13) being provided with an interchangeable supporting/alignment fixture (47) dedicated to the test object concerned.

10. The apparatus as set forth in any of the claims 6 to 9 **characterized by** a second transport device (19) which transports the test object into the placement position, the second transport device (19) being provided with an interchangeable supporting/alignment fixture (47) dedicated to the test object concerned.

11. The apparatus as set forth in any of the claims 6 to 10 **characterized in that** the supporting fixture comprises vacuum suckers (51).

12. The apparatus as set forth in any of the claims 6 to 11 **characterized in that** the alignment fixture (47) comprises pilot spikes (49) cooperating with holes (55) drilled in the test object.

## Revendications

1. Procédé pour la manipulation entièrement automatique d'échantillons à contrôler électriquement, en particulier des produits formés en plaques, de préférence des cartes électroniques, dans lequel ont lieu les étapes suivantes:
- alimentation en échantillons à contrôler disposés à plat les uns sur les autres sous une forme telle qu'une pile de produits;
- décalage des échantillons à contrôler disposés à plat les uns sur les autres relativement au ou au voisinage du(es) échantillon(s) suivant la hauteur la pile de produits et de la contrepression de la pile de produits à un contour dépendant de la hauteur d'une butée avec l'aide d'un poussoir, qui possède un contour dépendant de la hauteur adapté au contour de la butée;
- alignement de chaque échantillon supérieur dans une première position d'alignement;
- déplacement de l'échantillon à contrôler supérieur jusqu'à une position de contrôle
- mise en oeuvre du contrôle électrique et pose de l'échantillon contrôlé dans au moins une position de classement.

2. Procédé selon la revendication 1, dans lequel l'échantillon à contrôler est placé en second lieu avant la montée, dans une position d'alignement plus précise.

3. Procédé suivant l'une des revendications précédentes, dans lequel l'échantillon à contrôler est abaissé dans position de contrôle et un alignement a lieu pendant la descente.

4. Procédé suivant l'une des revendications précédentes. dans lequel l'échantillon à contrôler est déplacé en fonction du résultat du contrôle jusqu'à au moins une des deux positions de classement possibles.

5. Procédé suivant l'une des revendications précédentes, dans lequel l'échantillon à contrôler supérieur est prélevé de la pile de produits en position de sortie pour prendre le suivant.

6. Dispositif pour la mise en oeuvre du procédé suivant une ou plusieurs des revendications précédentes, caractérisé par une table d'élévation (27), qui soulève la pile de produits (11) en direction verticale, et un poussoir déplaçable (31), qui contient dans la direction longitudinale de la pile de produits un des échantillons et agit sur une face latérale d'un échantillon dans la pile de produits (11) et des échantillons à contrôler qui présentent un contour dépendant de la hauteur qui est adapté au contour du poussoir (31).

7. Dispositif selon la revendication 6, caractérisé en ce que le poussoir (31) exécute un mouvement ascendant cyclique, dans lequel la cadence de cycle est ajustée et que chaque échantillon à contrôler est soumis plusieurs fois au poussoir jusqu' au retrait de la pile de produits (11).

8. Dispositif selon la revendication 6 ou 7, caractérisé en ce que la face latérale (39) est inclinée dans au moins un secteur (B) par rapport à la verticale.

9. Dispositif suivant l'une des revendications 6 à 8, caractérisé en ce qu'il présente un premier dispositif de transfert (13) pour déplacer l'échantillon dans la position de contrôle, avec au niveau du premier dispositif de transfert (13) un dispositif d'alignement et de support démontable (47) spécial pour le contrôle.

10. Dispositif suivant l'une des revendications 6 à 9, caractérisé en ce qu'il présente un deuxième dispositif de transfert (13) pour déplacer l'échantillon en position de classement, avec au niveau du deuxième dispositif de transfert un dispositif de support démontable (47) spécial pour le contrôle.

11. Dispositif suivant l'une des revendications 6 à 10, caractérisé en ce qu'il présente des aspirateurs de vide (51) de dispositif support (47).

12. Dispositif suivant l'une des revendications 6 à 11, caractérisé en ce qu'il présente des broches d'alignement (49) du dispositif de sortie (47), qui coopèrent avec les perçages (55) des échantillons à contrôler.
